# EUROPÄISCHE PATENTSCHRIFT

(11) **EP 1 714 360 B1**
(45) Veröffentlichungstag und Bekanntmachung des Hinweises auf die Patenterteilung: **22.08.2007**
(21) Anmeldenummer: 05700361.8
(22) Anmeldetag: 09.02.2005
(51) Int. Cl.: H01S 5/06, H01S 5/14, H01S 3/102, H01S 3/105

(54) **LICHTEINHEIT UND VERFAHREN ZUR ERZEUGUNG VON LICHTSTRAHLEN**
LIGHT UNIT AND METHOD FOR GENERATING LIGHT RAYS
UNITE D'ECLAIRAGE ET PROCEDE DE PRODUCTION DE FAISCEAUX LUMINEUX

(30) Priorität: 11.02.2004 WO PCT/CH2004/000079
(43) Veröffentlichungstag der Anmeldung: 25.10.2006
(73) Patentinhaber: Technomedica AG, 8852 Wollerau (CH)
(72) Erfinder: LINDER, Patrick, CH-5318 Mandach (CH)
(74) Vertreter: Rigling, Peter Daniel
(86) Internationale Anmeldenummer: PCT/CH2005/000070
(87) Internationale Veröffentlichungsnummer: WO 2005/078878

(56) Entgegenhaltungen:
- DE-A1- 4 215 797
- FR-A- 1 382 706
- US-A- 4 935 935
- US-A- 4 953 166
- US-B1- 6 192 059
- US-B1- 6 396 083
- OWYOUNG A ET AL: "STRESS-INDUCED TUNING OF A DIODE-LASER-EXCITED MONOLITHIC ND:YAG LASER" OPTICS LETTERS, OPTICAL SOCIETY OF AMERICA, WASHINGTON, US, Bd. 12, Nr. 12, Dezember 1987 (1987-12), Seiten 999-1001, XP000710557 ISSN: 0146-9592
- PATENT ABSTRACTS OF JAPAN Bd. 012, Nr. 291 (E-644), 9. August 1988 (1988-08-09) & JP 63 066983 A (KISO KAISEKI KENKYUSHO:KK), 25. März 1988 (1988-03-25) in der Anmeldung erwähnt
- KOMIYAMA S ET AL: "REMARKABLE EFFECTS OF UNIAXIAL STRESS ON THE FAR-INFRARED LASER EMISSION IN P-TYPE GE" PHYSICAL REVIEW, B. CONDENSED MATTER, AMERICAN INSTITUTE OF PHYSICS. NEW YORK, US, Bd. 38, Nr. 2, 15. Juli 1988 (1988-07-15), Seiten 1274-1280, XP000029430 ISSN: 0163-1829 in der Anmeldung erwähnt

## Beschreibung

Die vorliegende Erfindung betrifft eine Lichteinheit nach dem Oberbegriff von Patentanspruch 1 sowie ein Verfahren zur Erzeugung von Lichtstrahlen.

Die Erzeugung von Laserstrahlen mit unterschiedlichen Wellenlängen mit der gleichen Lasereinheit ist an und für sich bekannt. So wurde bereits vorgeschlagen, den Laserstrahl eines Weisslichtlasers mit Hilfe von Filtern oder Prismen aufzuspalten, um so die gewünschte Farbkomponente, d.h. Wellenlänge, zu extrahieren. Des Weiteren ist es bekannt, die Abmessungen des bei Lasereinheiten vorhandenen Resonators mit Hilfe einer entsprechenden Mechanik zu verändern, womit auch die Wellenlänge des erzeugten Laserlichtes verändert werden kann, allerdings lediglich von einem Mode in einen anderen. In Bezug auf den Weisslicht- bzw. Buntlichtlaser wird auf eine Pressemitteilung vom 16. September 2003 der Universität Bonn, Deutschland, verwiesen. Darin wird ein neuer Laser beschrieben, mit dem die Erzeugung von Weisslicht auf einfache Weise und kostengünstig möglich ist. Mit Hilfe eines geeigneten Prismas wird das weisse Licht in die Farbkomponenten zerlegt, wobei die benötigte Farbe dann ausgewählt werden kann. In Bezug auf die erstgenannte Technik wird auf die Publikation von Jeff Hecht mit dem Titel "Understanding Lasers" (IEEE Press, 1992, S. 296-297) verwiesen.

Die bekannten Lasereinheiten weisen aber ungenügende Eigenschaften auf, und zwar sowohl hinsichtlich der Möglichkeit, eine gewisse Wellenlänge einstellen zu können, als auch hinsichtlich der Kohärenz der erhaltenen Laserstrahlen.

Ferner sind Lasereinheiten bekannt, bei denen mit Hilfe eines Druckelementes ein seitlicher Druck auf die aktive Schicht eines Halbleiters ausgeübt wird, um die Wellenlänge des emittierenden Lichtes zu verändern. Diesbezüglich wird auf die folgenden Druckschriften verwiesen:
- FR-1 382 706;
- JP-63 066 983;
- Publikation von S. Komiyama and S. Kuroda mit dem Titel "Remarkable effects of uniaxial stress on the far-infrared laser emission in p-type Ge" (Physical Review, B. Condensed Matter, American Institute of Physics, New York, USA, Bd. 38, Nr. 2, 15. Juli 1988, Seiten 1274 bis 1275).

Mit den bekannten Lasereinheiten kann die Wellenlänge nur in einem relativ kleinen Bereich variiert werden, was sich insbesondere aus den in der letztgenannten Druckschrift beschriebenen Resultaten ergibt.

Ferner sind Lasereinheiten bekannt, bei denen die Wellenlänge durch Verschieben von einem oder mehreren Spiegeln variiert wird. Diesbezüglich wird stellvertretend auf DE-42 15 797 A1, US-6 396 083 B1 oder US-2003/0012249 A1 verwiesen. Allerdings lässt sich auch bei diesen bekannten Lasereinheiten die Wellenlänge nur in einem bestimmten Bereich variieren, nämlich indem ein Mode des Lasers ausgewählt wird.

Der vorliegenden Erfindung liegt daher die Aufgabe zugrunde, eine Lichteinheit anzugeben, welche die vorstehend genannten Nachteile nicht aufweist.

Diese Aufgabe wird durch die im kennzeichnenden Teil von Anspruch 1 angegebenen Massnahmen gelöst. Vorteilhafte Ausgestaltungen der Erfindung sowie ein Verfahren zur Erzeugung von Lichtstrahlen mit unterschiedlichen Wellenlängen sind in weiteren Ansprüchen angegeben.

Die Erfindung weist die folgenden Vorteile auf: Indem die Spiegeleinheit und/oder das Ausgangsfenster durch mindestens ein Verschiebungselement in Abhängigkeit der durch das Druckerzeugungselement auf die Lichtquelleneinheit erzeugten Kraft relativ zur Trägereinheit verschiebbar und/oder relativ zur Längsachse kippbar sind, ist die Möglichkeit geschaffen, die Wellenlänge der Lichtstrahlen über einen grossen Bereich einstellen zu können. Es ist somit durch die Kombination der Einstellung der Wellenlänge über die Kraft auf die Lichtquelleneinheit bei gleichzeitiger Verschiebung des Ausgangfensters und/oder der Spiegeleinheit entlang der Längsachse der Trägereinheit eine exakte Einstellung der Wellenlänge einer Lichteinheit möglich, welche bisherige Einstellungsmöglichkeiten bei weitem übertreffen.

Wird als Lichtquelleneinheit zudem eine Laserdiodeneinheit eingesetzt, wird erstmals die Voraussetzung geschaffen, durch die Einstellung des Abstands zwischen der Spiegeleinheit und dem Ausgangfenster als Vielfaches der über das Druckerzeugungselement eingestellten halben Wellenlänge ein maximal kohärentes Licht erhalten zu können.

Die Erfindung wird nachfolgend mit Bezug auf die in den Zeichnungen dargestellten Ausführungsformen näher beschrieben. Dabei handelt es sich um beispielhafte Ausführungsformen, die zum Verständnis der in den Ansprüchen beanspruchten Gegenstände dienen. Es zeigen:
- Fig. 1A,: in schematischer und perspektivischer Darstellung, einen Teil einer Lichteinheit, wobei eine Schnittebene parallel zu einer Längsachse und eine weitere Schnittebene quer zur Längsachse liegen,
- Fig. 1B,: in schematischer und perspektivischer Darstellung gemäss Fig. 1A, einen Teil einer weiteren Ausführungsform einer Lichteinheit,
- Fig. 2: ein Ausgangfenster zur Verwendung bei dem in Fig. 1A bzw. 1B dargestellten Teil der Lichteinheit,
- Fig. 3: das Ausgangfenster gemäss Fig. 2 in einem Schnitt parallel zur Längsachse gemäss Fig. 1A bzw. 1B,
- Fig. 4: die vollständig zusammengebaute Lichteinheit gemäss den Fig. 1A, 1B, 2 und 3,
- Fig. 5A und 5B: jeweils einen Schnitt quer zur Längsachse einer Lichteinheit und
- Fig. 6: eine schematischen Darstellung einer erfindungsgemässen Ausführungsvariante, bei der eine Spiegeleinheit und ein Ausgangsfenster stets mittig in Bezug auf eine Lichtquelleneinheit angeordnet sind.

In den folgenden Ausführungen wird eine Lasereinheit als Spezialfall einer Lichtquelle beschrieben. Die Lichtquelle ist dabei so definiert, dass diese nicht notwendigerweise Lichtstrahlen erzeugt, welche die an Laserstrahlen gesetzten Bedingungen erfüllen. Dies insbesondere auch dann nicht, wenn - wie in einer Ausführungsform vorgesehen - in der Lichtquelle als Lichtquelleneinheit eine Laserdiodeneinheit zum Einsatz kommt. Damit kann zur Erläuterung von spezifischen Ausführungsformen, bei denen keine Laserstrahlen erzeugt werden, grundsätzlich der Begriff Lasereinheit durch Lichteinheit ersetzt werden, ohne dass hierdurch das erfindungsgemässe Prinzip verändert wird.

In Fig. 1A ist eine erfindungsgemässe Lasereinheit 2 dargestellt. Es handelt sich hierbei um eine Halbleiterlasereinheit, die beispielsweise auf GalliumArsenid basiert. Die erfindungsgemässe Lasereinheit 2 zeichnet sich durch eine hohe Zielgenauigkeit aus. Dabei können mit der erfindungsgemässen Lasereinheit 2 beispielsweise Wellenlängen von 400nm bis 700nm erzeugt werden.

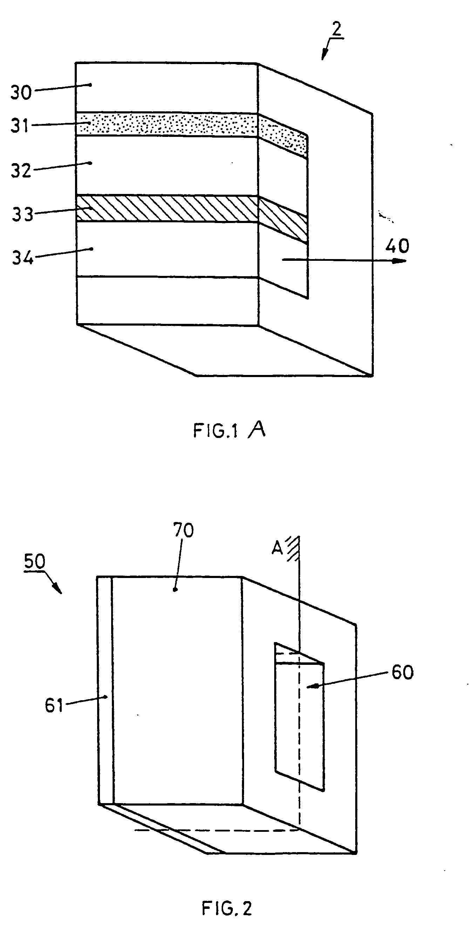

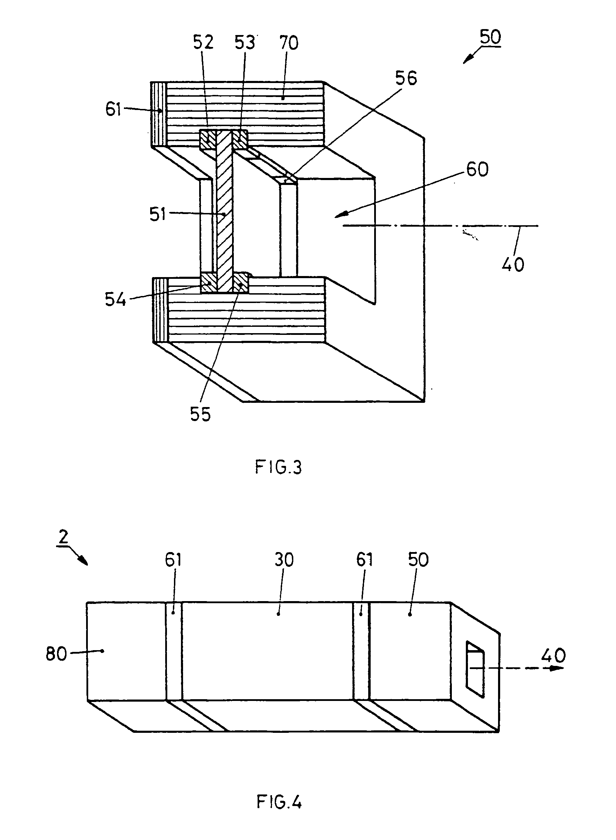

Fig. 1A zeigt den schematischen Aufbau eines Teils der Lasereinheit 2 anhand eines Schnittes parallel zu einer Längsachse 40. Die als Laserstrahlen erzeugten Lichtwellen pflanzen sich parallel zur Längsachse 40 fort, wobei eine Spiegeleinheit und ein Ausgangsfenster, das als teildurchlässiges Fenster realisiert ist, in Fig. 1A nicht dargestellt sind, aber anhand der Fig. 2 und 3 erläutert werden. Das teildurchlässige Fenster kann beispielsweise auch ein so genanntes Brewster-Fenster sein.

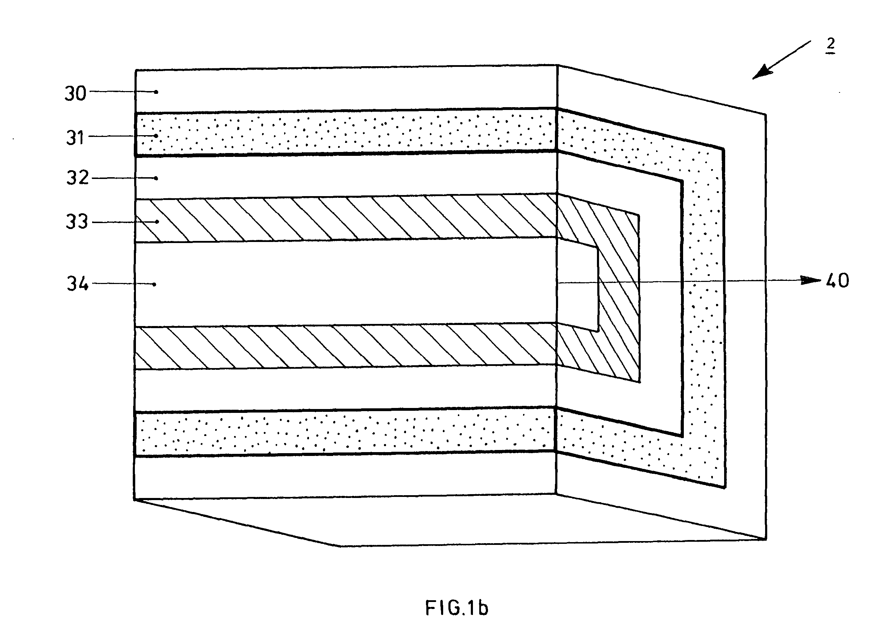

Eine Trägereinheit 30, die aus einem massiven wärmeleitenden Material - beispielsweise aus Messing oder Platin - besteht und die als Gehäuseteil angesehen werden kann, umfasst einen eigentlichen Kern der Lasereinheit 2, nämlich eine Laserdiodeneinheit 34, in der im Übergangsbereich zwischen p- und n-Schicht in bei Halbleiterlasern bekannter Weise Laserstrahlen erzeugt werden. Die als Laserdiodeneinheit 34 bezeichnete Schicht befindet sich gemäss Fig. 1 unmittelbar auf der Trägereinheit 30. Es folgt, ausgehend von der Laserdiodeneinheit 34 eine erste Isolationsschicht 33, ein Piezoelement 32 als Druckerzeugungselement und eine zweite Isolationsschicht 31, welche auf deren anderen Seite auf der umlaufenden Trägereinheit 30 aufliegt. Damit ist das Piezoelement 32 elektrisch isoliert.

Mit dem vorstehend beschriebenen Aufbau der Lasereinheit 2 besteht nun die Möglichkeit, mittels einer im Piezoelement 32 erzeugten Kraft auf die Laserdiodeneinheit 34 einzuwirken, um so die Wellenlänge zu verändern, da der Abstand des Valenzbandes zum Leitungsband - und damit die Wellenlänge - von der auf die Laserdiodeneinheit 34 einwirkenden Kraft abhängig ist.

Das Piezoelement 32 ist vorzugsweise aus einem TurmalinKristall gefertigt, der an seiner Oberfläche mit einer Silberschicht versehen ist, die durch Aufdampfung erzeugt worden ist und die zur Kontaktierung und damit zur Steuerung des ganzen Piezoelementes 32 verwendet wird. Anstelle einer Silberschicht kann auch Aluminium oder eine andere Metallschicht aufgedampft werden.

Wie bereits erläutert worden ist, sind zur Erzeugung eines Laserstrahles mit der Lasereinheit 2 sowohl eine Spiegeleinheit als auch ein Ausgangsfenster erforderlich, die im Wesentlichen quer zur Längsachse 40 der Lasereinheit 2 (Fig. 1A bzw. 1B) angeordnet sind. Während der rückwärtige Spiegel die durch die Laserdiodeneinheit 34 erzeugten Lichtstrahlen möglichst vollständig reflektiert, hat das Ausgangsfenster die Aufgabe, Lichtstrahlen, die vorgegebene Bedingungen erfüllen, aus der Lasereinheit 2 - eben durch das teildurchlässige Fenster - austreten zu lassen. Weitere Informationen können der Druckschrift "Understanding Lasers" von Jeff Hecht (Seiten 110 und 111, Second Edition, IEEE Press, New York, 1992) entnommen werden.

In Fig. 1B ist eine weitere Ausführungsform eines Teils der Lasereinheit 2 anhand eines Schnittes parallel zu einer Längsachse 40 analog zu Fig. 1A dargestellt. Wie bereits bei der Ausführungsform gemäss Fig. 1A bildet auch die Trägereinheit 30 der Ausführungsform gemäss Fig. 1B einen Hohlraum, in dem zwei Isolationsschichten 31 und 33, ein Piezoelement 32 und eine Laserdiodeneinheit 34 enthalten sind. Im Unterschied zur Ausführungsvariante gemäss Fig. 1A wird die Laserdiodeneinheit 34 zunächst von der ersten Isolationsschicht 33, anschliessend vom Piezoelement 32 als Druckerzeugungselement, dann von der zweiten Isolationsschicht 31 und schliesslich von der Trägereinheit 30 umfasst. Damit kann mit dem Druckerzeugungselement 32 eine Kraft erzeugt werden, die von allen radialen Richtungen, d.h. im Wesentlichen senkrecht zur Längsachse 40, auf die Laserdiodeneinheit 34 einwirkt.

In Fig. 2 ist ein Ausgangsfenster 50 dargestellt, wie es axial an das in Fig. 1 dargestellte Trägerelement 30 angeordnet wird. Das Ausgangsfenster 50 besteht im Wesentlichen aus einem Rahmenelement 70 und einer seitlich angeordneter Isolationsschicht 61, wobei sowohl durch das Rahmenelement 70 als auch durch die Isolationsschicht 61 eine Öffnung 60 vorgesehen ist. Des Weiteren ist in Fig. 2 eine Schnittebene A-A eingezeichnet, welche die Grundlage für den in Fig. 3 dargestellten Schnitt durch das Ausgangsfenster 50 bildet.

Fig. 3 zeigt das in Fig. 2 dargestellte Ausgangsfenster 50 im Schnitt gemäss Schnittebene A-A (Fig. 2). Durch den Schnitt parallel zur Längsachse 40 wird das Rahmenelement 70 zum U-förmigen Teil, in das ein teildurchlässiges Fenster 51 eingelegt ist, das im Wesentlichen senkrecht auf die Fortpflanzungsrichtung, d.h. der Längsachse 40, steht. Eine Verschiebung des teildurchlässigen Fensters 51 sowohl translatorisch in axialer Richtung als auch als Kippbewegung um die Längsachse 40 wird mit Hilfe von Positionselementen 52 bis 56 (im Folgenden auch etwa Verschiebungselemente genannt) erreicht, die wiederum als Piezoelemente ausgebildet sind. Damit für die Bewegungen des teildurchlässigen Fensters 51 drei Freiheitsgrade zur Verfügung stehen, sind die Positionselemente 52 bis 56 in der in Fig. 3 dargestellten Ausführungsform in den Ecken des viereckigen teildurchlässigen Fensters 51 angeordnet. Des Weiteren sind die Positionselemente 52 bis 56 einzeln über eine elektrische Verbindung kontaktiert, so dass die Positionselemente 52 bis 56 unabhängig voneinander angesteuert werden können. Die Steuerung erfolgt beispielsweise über eine zentrale Kontrolleinheit, die nicht weiter dargestellt ist.

Die Spiegeleinheit, welche die in der Laserdiodeneinheit 34 (Fig. 1) erzeugten Lichtstrahlen möglichst vollständig und verlustfrei reflektieren soll, kann als fixe Spiegelfläche nach bekanntem Stand der Technik realisiert werden.

Bei einer weiteren Ausführungsform der Erfindung wird vorgeschlagen, die Spiegeleinheit nicht fix zu realisieren, sondern analog zu dem anhand der Fig. 2 und 3 erläuterten teildurchlässigen Fenster 51. Bei dieser Ausführungsvariante ist zwar kein teildurchlässiges Fenster notwendig. Daher wird anstelle des in Fig. 3 dargestellten teildurchlässigen Fensters 51 eine reflektierende Oberfläche benötigt, die beispielsweise durch Aufdampfen einer Metallschicht auf einen Träger erhalten wird. Die übrigen Elemente, d.h. die Positions- bzw. Verschiebungselemente, werden zur Steuerung der reflektierenden Oberfläche verwendet. Damit ist eine Lasereinheit 2 geschaffen, die gegenüber der Ausführungsform mit einer fixen Spiegelfläche (Spiegelelement) einen erweiterten Einsatzbereich aufweist, was im Lichte der nachfolgenden Erläuterungen besonders deutlich wird.

Bekanntlich ist zur Erhaltung einer Resonanz in einer Lasereinheit von entscheidender Bedeutung, dass der Abstand zwischen Spiegelfläche (Spiegelelement) und teildurchlässigem Fenster ein Vielfaches oder die Exakte der interessierenden halben Wellenlänge (λ/2) beträgt. Wird nun gemäss der vorliegenden Erfindung die Wellenlänge durch Veränderung mittels des Piezoelementes 32 (Fig. 1) verändert, so kann vor allem dann eine effiziente Lasereinheit (d.h. maximal kohärentes Licht) erhalten werden, wenn der Abstand zwischen der Spiegeloberfläche und dem teildurchlässigen Fenster 51 als Vielfaches oder gleich der interessierenden halben Wellenlänge eingestellt wird.

Es hat sich gezeigt, dass durch die Kombination der allseitigen Kraftausübung auf die Laserdiodeneinheit 34 (Fig. 1B) und durch die gleichzeitig vorgenommene korrekte Einstellung des Abstandes zwischen Spiegeloberfläche und teildurchlässigem Fenster 51 eine äusserst vielfältig einsetzbare Lasereinheit 2 (Fig. 1) zur Verfügung gestellt wird, welche sich insbesondere dadurch auszeichnet, dass sich die Wellenlänge beispielsweise zwischen 400 nm und 700 nm elektronisch einstellen lässt, ohne dass Prismen oder Farbfilter notwendig sind bzw. ohne dass eine Frequenzverdoppelung vorgenommen werden muss.

Fig. 4 zeigt die Lasereinheit 2, bestehend aus den anhand der Fig. 1A, 1B, 2 und 3 erläuterten Einzelteilen. So ist das Trägerelement 30 gemäss Fig. 1 zwischen dem Rahmenelement 50 mit dem teildurchlässigen Fenster und einer Spiegeleinheit 80 angeordnet, wobei jeweils eine Isolationsschicht 61 zwischen den Einzelteilen 80, 30, 56 zur elektrischen und thermischen Isolation vorhanden sind.

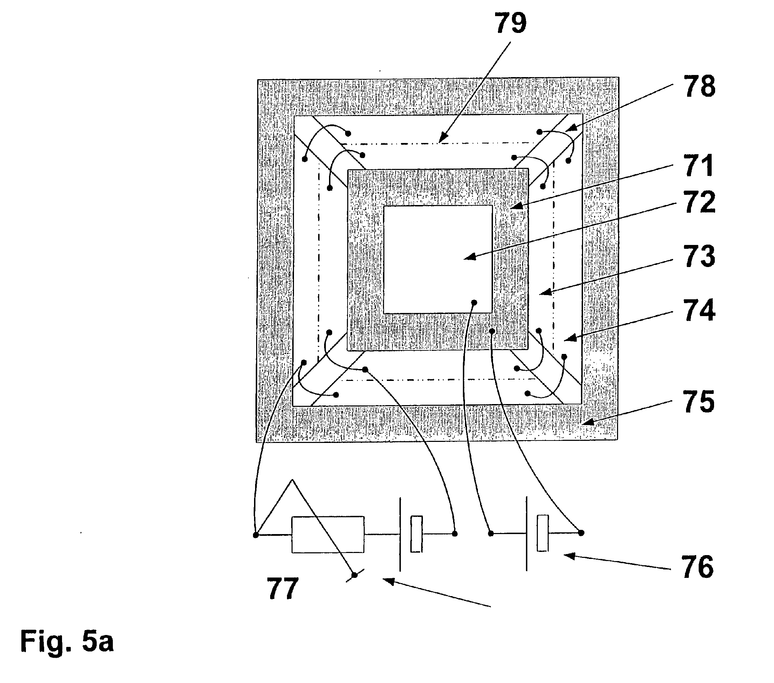

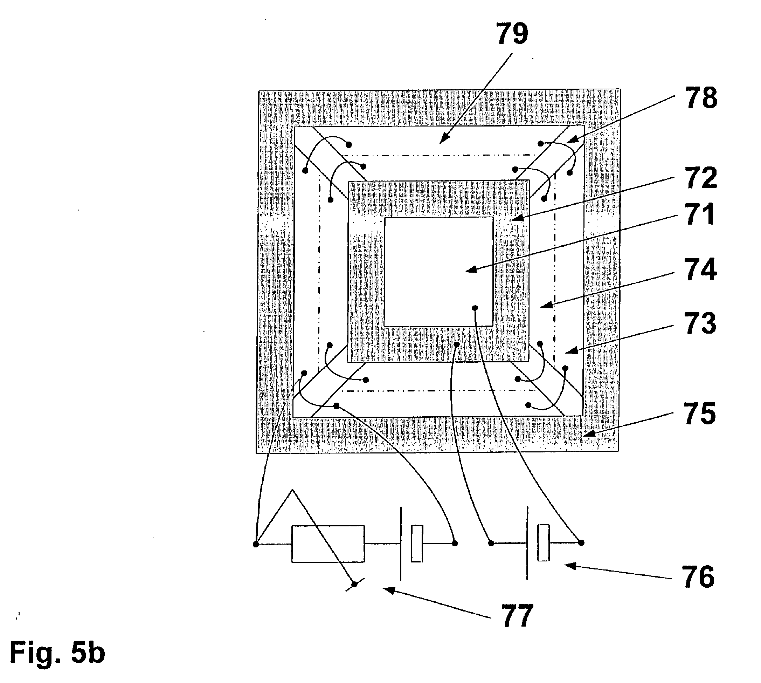

Fig. 5A und 5B zeigen mittels Epitaxie oder auch durch andere Verfahren hergestellte Laserdiodeneinheiten, die auf allen vier Seiten des quadratischen Querschnittes Druckerzeugungselemente 73, 74 aufweisen, wobei die vier Teile der Druckerzeugungselemente 73, 74 in den jeweiligen Ecken beabstandet sind. Für die gleichzeitige Betätigung aller vier Teile der Druckerzeugungselemente 73, 74 sind diese mit Hilfe von Bonddrähten elektrisch miteinander verbunden (wie in den Fig. 5A und 5B dargestellt) oder direkt mit einer hierfür vorgesehenen Spannungsquelle bzw. Steuereinheit 77 gekoppelt.

Zur weiteren Verdeutlichung wird in Fig. 5A ein p-n-Übergang und in Fig. 5B ein n-p-Übergang für die Laserdiodeneinheit dargestellt. Aus den Fig. 5A und 5B wird ersichtlich, dass die Druckerzeugungselemente 73, 74 in Bezug auf die Laserdiodeneinheit gegenteilige Pole aufweist, womit eine gegenseitige ungünstige Beeinflussung zwischen Druckerzeugungselement und Laserdiodeneinheit verhindert werden kann.

Die in den Fig. 5A bzw. 5B verwendeten Hinweiszeichen können wie folgt zugewiesen werden:

| | |
|---|---|
| 71 | n (Kathode) der Laserdiodeneinheit; |
| 72 | p (Anode) der Laserdiodeneinheit; |
| 73 | n-Anschluss des Druckerzeugungselementes; |
| 74 | p-Anschluss des Druckerzeugungselementes; |
| 75 | Trägerelement; |
| 76 | Quelle für die Laserdiodeneinheit; |
| 77 | Steuerschaltung zur Einstellung der auf die Laserdiodeneinheit wirkende Kraft; |
| 78 | Luftspalt zwischen den einzelnen Teilen der Druckerzeugungseinheit; |
| 79 | Druckerzeugungselement. |

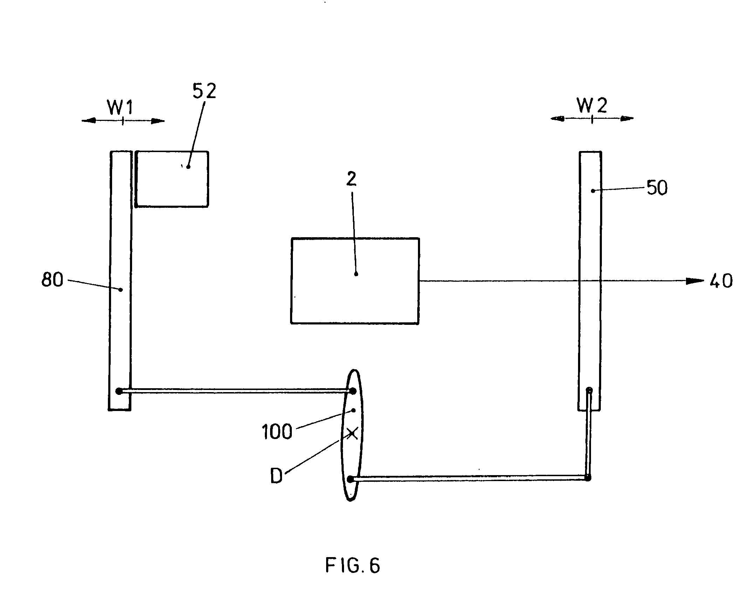

Fig. 6 zeigt in schematischer Darstellung eine erfindungsgemässe Vorrichtung mit der mittig zwischen der Spiegeleinheit 80 und dem Ausgangsfenster 50 angeordneten Lasereinheit 2, die beispielsweise in der im Zusammenhang mit Fig. 5A bzw. 5B beschriebenen Art und Weise realisiert ist. Diese Ausführungsform zeichnet sich dadurch aus, dass sowohl die Spiegeleinheit 80 als auch das Ausgangsfenster 50 in Abhängigkeit der durch das Druckerzeugungselement (in Fig. 6 nicht dargestellt) erzeugten und auf die Laserdiodeneinheit einwirkenden Kraft verschoben wird, und zwar derart, dass sich die Laserdiodeneinheit stets mittig zwischen der Spiegeleinheit 80 und dem Ausgangsfenster 50 befindet bzw. die Diodenlaserfassette eine halbe Wellenlänge oder ein Vielfaches der halben Wellenlänge zur Spiegeleinheit entfernt ist, wobei dies davon abhängig ist, ob die Diodenlaserfassette entspiegelt ist oder nicht. Ist nämlich die Diodenlaserfassette entspiegelt, so baut sich zwischen der Diodenlaserfassette und der Spiegeleinheit keine zusätzliche Resonanz auf. Ist hingegen die Diodenlaserfassette nicht entspiegelt, so baut sich zwischen der Diodenlaserfassette und der Spiegeleinheit eine zusätzliche Resonanz auf, was bei inkorrekter Distanz zu zusätzlichen Wellen und damit zu einem Verlust führt. Dies mit Abweichungen in Abhängigkeit von der Distanz der Spiegeleinheiten gegenüber der Diodenlaserfassette und gilt für beide Austrittseiten der Laserdiodeneinheit. Dies wird beispielsweise mit Hilfe der in Fig. 6 dargestellten synchronen Drehvorrichtung 100 erreicht, die im Punkt D drehbar gelagert ist. Wird nun mit dem Verschiebungselement 52 die Spiegeleinheit 80 in eine Richtung W1 verschoben, so erfolgt über die synchrone Drehvorrichtung 100 eine 1:1-Übertragung auf das Ausgangsfenster 50, so dass dieses eine betragsmässige identische Verschiebung in Richtung W2 erfährt.

Eine mittige Ausrichtung der Laserdiodeneinheit bzw. deren Fassette ergibt als zusätzlicher Vorteil eine optimierte Leistungsausnutzung.

Anstelle der synchronen Drehvorrichtung 100 können selbstverständlich auch zwei oder mehrere Verschiebungselemente 52 vorgesehen werden, die derart abgestimmt und angeordnet sind, dass sich die Laserdiodeneinheit stets mittig zwischen der Spiegeleinheit 80 und dem Ausgangsfenster 50 befindet.

## Patentansprüche

1. Lichteinheit zur Erzeugung von Lichtstrahlen mit unterschiedlichen Wellenlängen, umfassend
- eine Lichtquelleneinheit (34),
- eine Spiegeleinheit (80),
- eine Trägereinheit (30),
- ein Ausgangsfenster (50) mit einer Öffnung (60) und
- ein Druckerzeugungselement (32),
wobei die Lichtquelleneinheit (34) und das Druckerzeugungselement (32) in der Trägereinheit (30) enthalten sind, die eine im Wesentlichen parallel zu den erzeugten Lichtstrahlen verlaufende Längsachse (40) aufweist, wobei die Spiegeleinheit (80) und das Ausgangsfenster (50) an gegenüberliegenden Enden der Trägereinheit (30) angeordnet sind und wobei mit dem Druckerzeugungselement (32) eine Kraft erzeugt wird, die auf die Lichtquelleneinheit (34) wirkt, **dadurch gekennzeichnet, dass** die Spiegeleinheit (80) und/oder das Ausgangsfenster (50) durch mindestens ein Verschiebungselement (52,..., 55) in Abhängigkeit der durch das Druckerzeugungselement (32) auf die Lichtquelleneinheit (34) erzeugten Kraft relativ zur Trägereinheit (30) verschiebbar und/oder relativ zur Längsachse (40) kippbar sind.

2. Lichteinheit nach Anspruch 1, **dadurch gekennzeichnet, dass** mit dem Druckerzeugungselement (32) von mehreren Seiten eine Kraft auf die Lichtquelleneinheit (34) erzeugbar ist, wobei die Kraft vorzugsweise im Wesentlichen senkrecht auf die Längsachse (40) wirkt.

3. Lichteinheit nach Anspruch 1 oder 2, **dadurch gekennzeichnet, dass** mit dem Druckerzeugungselement (32) eine rundum gleichmässige Kraft auf die Lichtquelleneinheit (34) erzeugbar ist.

4. Lichteinheit nach einem der vorangehenden Ansprüche, **dadurch gekennzeichnet, dass** das Druckerzeugungselement (32) vom Typ Piezoelement ist, das vorzugsweise auf Natriumpersulfat, Natriumhydroxyd bzw. Kupfersulfat basiert.

5. Lichteinheit nach Anspruch 4, **dadurch gekennzeichnet, dass** das Piezoelement (32) ein Turmalinkristall ist, der zur Kontaktierung auf den der Lichtquelleneinheit (34) zugewandten und abgewandten Seiten eine elektrisch leitende Schicht aufweist, vorzugsweise eine Silber- oder Aluminiumschicht.

6. Lichteinheit nach einem der Ansprüche 1 bis 5, **dadurch gekennzeichnet, dass** das Ausgangsfenster (50) ein teildurchlässiges Fenster oder ein Brewster-Fenster (51) ist.

7. Lichteinheit nach einem der Ansprüche 1 bis 6, **dadurch gekennzeichnet, dass** das Ausgangsfenster (50) und die Spiegeleinheit (80) derart verschiebbar sind, dass die Lichtquelleneinheit (34) stets mittig zwischen dem Ausgangsfenster (50) und der Spiegeleinheit (80) angeordnet ist.

8. Lichteinheit nach einem der vorangehenden Ansprüche, **dadurch gekennzeichnet, dass** das Verschiebungselement aus mindestens einem Piezoelement (52, ..., 56) besteht.

9. Lichteinheit nach einem der Ansprüche 1 bis 8, **dadurch gekennzeichnet, dass** zwischen der Spiegeleinheit (80) und der Trägereinheit (30) und/oder zwischen dem Ausgangsfenster (50) und der Trägereinheit (30) eine Isolationsschicht (61) vorgesehen ist.

10. Lichteinheit nach einem der Ansprüche 1 bis 9, **dadurch gekennzeichnet, dass** die Lichtquelleneinheit eine Laserdiodeneinheit (34), insbesondere vom Typ Halbleiterlaser, ist.

11. Verfahren zum Erzeugen von Lichtstrahlen mit unterschiedlichen Wellenlängen unter Verwendung einer Lichteinheit, umfassend
- eine Lichtquelleneinheit (34),
- eine Spiegeleinheit (80),
- eine Trägereinheit (30),
- ein Ausgangsfenster (50) mit einer Öffnung (60) und
- ein Druckerzeugungselement (32),
wobei die Lichtquelleneinheit (34) und das Druckerzeugungselement (32) in der Trägereinheit (30) enthalten sind, die eine im Wesentlichen parallel zu den erzeugten Lichtstrahlen verlaufende Längsachse (40) aufweist, wobei die Spiegeleinheit (80) und das Ausgangsfenster (50) an gegenüberliegenden Enden der Trägereinheit (30) angeordnet sind, wobei mit dem Druckerzeugungselement (32) eine Kraft erzeugt wird, die auf die Lichtquelleneinheit (34) wirkt, und wobei das Verfahren darin besteht, dass die Spiegeleinheit (80) und/oder das Ausgangsfenster (50) durch mindestens ein Verschiebungselement (52,..., 56) in Abhängigkeit der durch das Druckerzeugungselement (32) auf die Lichtquelleneinheit (34) erzeugten Kraft relativ zur Trägereinheit (30) verschoben und/oder relativ zur Längsachse (40) gekippt wird.

12. Verfahren nach Anspruch 11, **dadurch gekennzeichnet, dass** mit dem Druckerzeugungselement (32) von mehreren Seiten eine Kraft auf die Lichtquelleneinheit (34) erzeugt wird, wobei die Kraft vorzugsweise im Wesentlichen senkrecht auf die Längsachse (40) wirkt.

13. Verfahren nach Anspruch 11 oder 12, **dadurch gekennzeichnet, dass** mit dem Druckerzeugungselement (32) eine rundum gleichmässige Kraft auf die Lichtquelleneinheit (34) erzeugt wird.

14. Verfahren nach einem der Ansprüche 11 bis 13, **dadurch gekennzeichnet, dass** das Ausgangsfenster (50) und die Spiegeleinheit (80) derart verschoben werden, dass die Lichtquelleneinheit (34) stets mittig zwischen dem Ausgangsfenster (50) und der Spiegeleinheit (80) angeordnet ist.

15. Verfahren nach einem der Ansprüche 11 bis 14, **dadurch gekennzeichnet, dass** der Abstand zwischen der Spiegeleinheit (80) und dem Ausgangsfenster (50) derart eingestellt wird, dass dieser die Exakte oder ein Vielfaches der interessierenden halben Wellenlänge beträgt.

## Claims

1. Light unit for generating light beams having various wavelengths, comprising
- a light source unit (34),
- a mirror unit (80),
- a support unit (30),
- an exit window (50) having an opening (60), and
- a pressure-generating element (32),
the light source unit (34) and the pressure-generating element (32) being contained in the support unit (30), which exhibits a longitudinal axis (40) running substantially parallel to the generated light beams, the mirror unit (80) and the exit window (50) being arranged on opposite ends of the support unit (30), and a force being generated with the pressure-generating element (32), which force acts on the light source unit (34), **characterized in that** the mirror unit (80) and/or the exit window (50) are displaceable relative to the support unit (30) and/or tiltable relative to the longitudinal axis (40) by at least one displacement element (52, ..., 55) in dependence on the force generated by the pressure-generating element (32) on the light source unit (34).

2. Light unit according to claim 1, **characterized in that** a force on the light source unit (34) can be generated from a plurality of sides with the pressure-generating element (32), the force preferably acting substantially perpendicularly to the longitudinal axis (40).

3. Light unit according to claim 1 or 2, **characterized in that** a force, uniform all around, can be generated on the light source unit (34) with the pressure-generating element (32).

4. Light unit according to one of the foregoing claims, **characterized in that** the pressure-generating element (32) is of piezoelement type, preferably based on sodium persulfate, sodium hydroxide, or copper sulfate.

5. Light unit according to claim 4, **characterized in that** the piezoelement (32) is a tourmaline crystal that has an electrically conductive film, preferably a silver or aluminum film, for contacting on the sides facing toward and away from the light source unit (34).

6. Light unit according to one of claims 1 to 5, **characterized in that** the exit window (50) is a semitransparent window or a Brewster window (51).

7. Light unit according to one of claims 1 to 6, **characterized in that** the exit window (50) and the mirror unit (80) are displaceable in such fashion that the light source unit (34) is always arranged centrally between the exit window (50) and the mirror unit (80).

8. Light unit according to one of the foregoing claims, **characterized in that** the displacement element comprises at least one piezoelement (52, ..., 56).

9. Light unit according to one of claims 1 to 8, **characterized in that** there is an insulation layer (61) between the mirror unit (80) and the support unit (30) and/or between the exit window (50) and the support unit (30).

10. Light unit according to one of claims 1 to 9, **characterized in that** the light source unit is a laser diode unit (34), in particular of the semiconductor laser type.

11. Method for generating light beams having various wavelengths through the use of a light unit comprising
- a light source unit (34),
- a mirror unit (80),
- a support unit (30),
- an exit window (50) having an opening (60), and
- a pressure-generating element (32),
the light source unit (34) and the pressure-generating element (32) being contained in the support unit (30), which has a longitudinal axis (40) running substantially parallel to the generated light beams, the mirror unit (80) and the exit window (50) being arranged at opposite ends of the support unit (30), a force acting on the light source unit (34) being generated with the pressure-generating element (32), and the method consisting in that the mirror unit (80) and/or the exit window (50) are displaced relative to the support unit (30) and/or tilted relative to the longitudinal axis (40) by at least one displacement element (52, ..., 56) in dependence on the force generated by the pressure-generating element (32) on the light source unit (34).

12. Method according to claim 11, **characterized in that** a force on the light source unit (34) is generated from a plurality of sides with the pressure-generating element (32), the force preferably acting substantially perpendicularly to the longitudinal axis (40).

13. Method according to claim 11 or 12, **characterized in that** a force, uniform all around, can be generated on the light source unit (34) with the pressure-generating element (32).

14. Method according to one of claims 11 to 13, **characterized in that** the exit window (50) and the mirror unit (80) are displaced in such fashion that the light source unit (34) is always arranged centrally between the exit window (50) and the mirror unit (80).

15. Method according to one of claims 11 to 14, **characterized in that** the spacing between the mirror unit (80) and the exit window (50) is set such that this distance is exactly equal to, or a multiple of, half the wavelength of interest.

## Revendications

1. Unité d'éclairage pour la production de faisceaux lumineux à longueurs d'onde différentes, comprenant
- une unité de source lumineuse (34)
- une unité miroir (80),
- une unité support (30),
- une fenêtre de sortie (50) avec
- une ouverture (60) et
- un élément de production de pression (32),
ladite unité de source lumineuse (34) et l'élément de production de pression (32) étant contenus dans l'unité support (30) présentant un axe longitudinal (40) s'étendant essentiellement dans une direction parallèle aux faisceaux lumineux produits, ladite unité miroir (80) et la fenêtre de sortie (50) étant arrangées à des extrémités opposées de l'unité support (30) et l'élément de production de pression (32) produisant une force qui agit sur l'unité de source lumineuse (32), **caractérisée en ce que** l'unité miroir (80) et / ou la fenêtre de sortie (50) pouvant être déplacées par rapport à l'unité support (38) et / ou pouvant être basculées par rapport à l'axe longitudinal (40)au moyen d'au moins un élément de déplacement (52, 53, 54, 55) en fonction de la force produite par l'action de l'élément de production de pression (32) sur l'unité de source lumineuse (34).

2. Unité d'éclairage selon la revendication 1, **caractérisée en ce que** l'élément de production de pression (32) permet de produire une force sur l'unité de source lumineuse (34)à partir de plusieurs directions, la force agissant de préférence essentiellement perpendiculairement sur l'axe longitudinal (40).

3. Unité d'éclairage selon la revendication 1 ou 2, **caractérisée en ce que** l'élément de production de pression (32) permet de produire une force uniforme de toutes les directions sur l'unité de source lumineuse (34).

4. Unité d'éclairage selon l'une des revendications précédentes, **caractérisée en ce que** l'élément de production de pression (32) est du type élément piézoélectrique qui est de préférence basé sur le persulfate de sodium, l'hydroxyde de sodium respectivement le sulfate de cuivre.

5. Unité d'éclairage selon la revendication 4, **caractérisé en ce que** l'élément piézoélectrique (32)est un cristal de tourmaline qui porte, en vue d'être contacté sur les côtés en face et les côtés non-en face de l'unité de source lumineuse (34) une couche conductrice d'éléctricité, de préférence une couche en argent ou en aluminium.

6. Unité d'éclairage selon l'une des revendications 1 à 5, **caractérisée en ce que** la fenêtre sortie (50) est une fenêtre partiellement transparente ou une fenêtre Brewster (51).

7. Unité d'éclairage selon l'une des revendications 1 à 6, **caractérisée en ce que** la fenêtre de sortie (50) et l'unité miroir (80) peuvent être déplacées de telle manière, que l'unité de source lumineuse (34) soit toujours arrangée au milieu entre la fenêtre de sortie (50) et l'unité miroir (80).

8. Unité d'éclairage selon l'une des revendications précédentes, **caractérisée en ce que** l'élément de déplacement comprend au moins un élément piézoélectrique (50, 51, 52, 53, 54, 55, 56).

9. Unité d'éclairage selon l'une des revendications 1 à 8, **caractérisée en ce qu'**une couche isolante (61) est prévue entre l'unité miroir (80) et l'unité support (30) et / ou entre la fenêtre de sortie (50) et l'unité support (30).

10. Unité d'éclairage selon l'une des revendications 1 à 9, **caractérisée en ce que** l'unité de source lumineuse est une unité de diode laser (34), notamment du type laser semiconducteurs.

11. Procédé de production de faisceaux lumineux à longueurs d'onde différentes en utilisant une unité d'éclairage comprenant
- une unité de source lumineuse (34)
- une unité miroir (80),
- une unité support (30),
- une fenêtre de sortie (50) avec
- une ouverture (60) et
- un élément de production de pression (32),
ladite unité de source lumineuse (34) et l'élément de production de pression (32) étant contenus dans l'unité support (30) présentant un axe longitudinal (40) s'étendant essentiellement dans une direction parallèle aux faisceaux lumineux produits, ladite unité miroir (80) et la fenêtre de sortie (50) étant arrangées à des extrémités opposées de l'unité support (30) et l'élément de production de pression (32) produisant une force qui agit sur l'unité de source lumineuse (32), le procédé étant **caractérisé en ce que** l'unité miroir (80) et / ou la fenêtre de sortie (50) sont déplacées par rapport à l'unité support (38) et / ou sont basculées par rapport à l'axe longitudinal (40)au moyen d'au moins un élément de déplacement (52, 53, 54, 55) en fonction de la force produite par l'action de l'élément de production de pression (32) sur l'unité de source lumineuse (34).

12. Procédé selon la revendication 11, **caractérisée en ce que** l'on produit avec l'élément de production de pression (32) une force sur l'unité de source lumineuse (34)à partir de plusieurs directions, la force agissant de préférence essentiellement perpendiculairement sur l'axe longitudinal (40).

13. Procédé selon la revendication 11 ou 12, **caractérisé en ce que** l'on produit avec l'élément de production de pression (32) une force uniforme de toutes les directions sur l'unité de source lumineuse (34).

14. Procédé selon l'une des revendications 11 à 13, **caractérisée en ce que** la fenêtre de sortie (50) et l'unité miroir (80) sont déplacées de telle manière, que l'unité de source lumineuse (34) soit toujours arrangée au milieu entre la fenêtre de sortie (50) et l'unité miroir (80).

15. Procédé selon l'une des revendications 11 à 14, **caractérisé en ce que** la distance entre l'unité miroir et la fenêtre de sortie (50) est réglée de telle manière que cette distance soit égale exactement à la valeur ou à un multiple de la valeur de la demi-longueur d'onde intéressée.
